Europäisches Patentamt

European Patent Office

Office européen des brevets

(11) Veröffentlichungsnummer: **0 198 199 B1**

(12) **EUROPÄISCHE PATENTSCHRIFT**

(45) Veröffentlichungstag der Patentschrift: **17.06.92**

(21) Anmeldenummer: **86102956.9**

(22) Anmeldetag: **06.03.86**

(51) Int. Cl.⁵: **H01L 21/306, H01S 3/06**

(54) Verfahren zur nasschemischen Herstellung eines Oberflächengitters mit einer bestimmten Gitterkonstante auf der Oberfläche eines Substrats aus einem Kristallmaterial.

(30) Priorität: **19.04.85 DE 3514255**

(43) Veröffentlichungstag der Anmeldung:
**22.10.86 Patentblatt 86/43**

(45) Bekanntmachung des Hinweises auf die
Patenterteilung:
**17.06.92 Patentblatt 92/25**

(84) Benannte Vertragsstaaten:
**DE FR GB**

(56) Entgegenhaltungen:

**PATENT ABSTRACTS OF JAPAN, Band 8, Nr. 256 (E-280)[1693], 22. November 1984; & JP-A-59 127 895**

**PATENT ABSTRACTS OF JAPAN, Band 8, Nr. 250 (E-279)[1687], 16. November 1984; JP-A-59 126 693**

**JOURNAL OF APPLIED PHYSICS, Band 57, Nr. 1, 1. Januar 1985, Seiten 39-44, Woodbury, New York, US; R.M. LUM et al.: "Holographic photoelectrochemical etching of diffraction gratings in n-InP and n-GaInAsP for distributed feedback lasers"**

**JOURNAL OF THE ELECTROCHEMICAL SOCIETY, Band 130, Nr. 9, September 1983, Seiten 1934-1941, Manchester, New Hampshire, US; D.N. MacFadyen: "On the preferential etching of GaAs by H2SO4-H2O2-H2O"**

(73) Patentinhaber: **SIEMENS AKTIENGESELL-SCHAFT**
**Wittelsbacherplatz 2**
**W-8000 München 2(DE)**

(72) Erfinder: **Matz, Richard, Dr.**
**Naringerstrasse 24a**
**W-8152 Westerham(DE)**
Erfinder: **März, Reinhard, Dr.**
**Hofangerstrasse 79**
**W-8000 München 83(DE)**

# Beschreibung

Die Erfindung betrifft ein Verfahren zur naßchemischen Herstellung eines Oberflächengitters mit einer bestimmten Gitterkonstanten auf der Oberfläche eines Substrats aus einem Kristallmaterial nach dem Oberbegriff des Patentanspruchs 1 und wie es beispielsweise aus D. V. Podlesnik et al, Applied Physics Letters 43 (1983), Seite 1083 bekannt ist.

Der im Anspruch 1 angegebenen Erfindung liegt die Aufgabe zugrunde, Oberflächengitter zur erzeugen, deren Rillen ein V-förmiges Profil aufweist, wobei ein Aspektverhältnis von etwa 0,4 erhalten wird.

Die im Anspruch 1 angegebene Anisotropie einer Dunkelätzrate ist beispielsweise aus bekannt S. Iida und K. ito, Electrochem. Soc. 118 (1971), S.768 und wird auch in stark verdünnten Ätzmitteln beobachtet.

Zweckmäßig ist es, wenn gemäß Anspruch 2 für die Herstellung des vorläurigen Oberflachengitters und die Herstellung des eigentlichen Oberflächengitters das gleiche Ätzmittel verwendet wird, das zumindest im Dunkeln anisotrop wirkt.

Dieses Verfahren gestaltet sich besonders einfach, wenn gemäß Anspruch 3 zur Herstellung des eigontlichen Obeflächengitters nach der Herstellung des vorläufigen Oberflächengitters dieses letztgenannte Gitter im Dunkeln weiter in Kontakt mit dem Ätzmittel belassen wird.

Das erfindungsgemäße Verfahren, insbesondere das Verfahren nach Anspruch 3 gestattet es, auch im 0.2-0,3 um-Bereich Asnektverhältnisse von 0,4 z" erreichen, wobei unter Aspektverhältnis das Verhältnis zwischen der Tiefe und der Breite der jeweiligen Rillen des Gitters zu verstehen ist.

Die Erfindung wird anhand der Figuren in der nachfolgenden Beschreibung näher erläutert.

Die Figur 1 zeigt in perspektivischer Darstellung und schematisch einen Ausschnitt aus einem vorläufigen Oberflächengitter und

Figur 2 in der gleichen Darstellung das aus dem Gitter nach Figur 1 entstandene eigentliche Gitter.

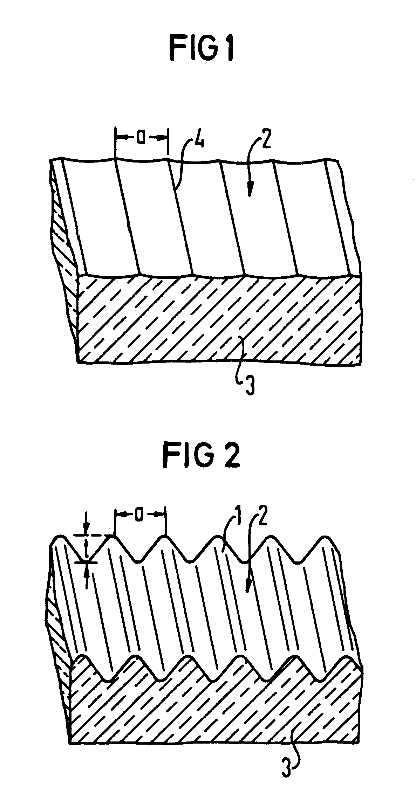

Das vorläufige Oberflächengitter 4 auf der Oberfläche 2 des Substrats 3 in Figur 1 mit der geringen Korrugation oder Welligkeit und der Gitterkonstanten a wird beispielsweise durch holografische Belichtung der Oberfläche 2 in dem Ätzmittel erzeugt, das auch für das anisotrope Dunkelätzen verwendet wird. Anschließend bleibt das Substrat 3 ohne Belichtung im Ätzmittel, das in der Dunkelheit in zumindest einer zur Oberfläche des Substrats schrägen Richtung am langsamsten ätzt. Bei diesem Ätzvorgang wird das in der Figur 2 gezeigte eigentliche Oberflächengitter 1 erhalten, das eine für integrieroptische Zwecke ausreichende Welligkeit und wieder die Gitterkonstante a aufweist.

Bei einer praktischen Herstellung eines eigentlichen Gitters 1 bestand das Substrat 3 aus n-dotiertem GaAs und das Ätzmittel aus einem Teil 25 %iger Schwelfesäure, einem Teil 30 %igem Wasserstoffperoxid und 50 Teilen Wasser, wobei sich die Prozentangaben als Volumenprozent verstehen. Zur Herstellung des vorläufigen Oberflächengitters 4 mit einer Gitterkonstanten a = 0,3 $\mu$m wurde etwa 3 Minuten lang mit dem Licht eines Argon-Lasers belichtet. Zur Herstellung des eigentlichen Gitters 1 blieb das vorläufige Gitter 4 etwa 10 Minuten lang bei Dunkelheit im Ätzmittel. Dabei bewirkte die Anisotropie des Ätzmittels eines Annäherung der Wände der Rillen des Gitters 1 an die (111)-Flächen des Kristalls, wodurch diese Rillen ein V-förmiges Profil aufweisen. Das Aspektverhältnis t/a betrug beim hergestellten eigentlichen Gitter etwa 0,4.

Mit dem erfindungsgemäßen Verfahren können bestimmte Strukturen der integrierten Optik, beispielsweise MCRW-DFB-Laser einfacher realisiert werden.

## Patentansprüche

1. Verfahren zur naßchemischen Herstellung eines Oberflächengitters (1) mit einer bestimmten Gitterkonstanten (a) auf der Oberfläche (2) eines Substrats (3) aus einem Kristallmaterial, wobei auf der Oberfläche (2) des Substrats (3) ein vorläufiges Oberflächengitter (4) mit der bestimmten Gitterkonstanten (a) aber mit relativ geringer Welligkeit durch Interferenzbelichtung der mit einem Ätzmittel unmittelbar in Kontakt stehenden Oberfläche (2) des Substrats (3) erzeugt wird, und wobei dann zur Herstellung des eigentlichen Oberflächengitters (1) das vorläufige Oberflächengitter (4) eine bestimmte Zeit lang in Kontakt mit einem anisotropen, in zumindest einer zur Oberfläche des Substrats (3) schrägen Richtung am langsamsten ätzenden Ätzmittel gehalten wird, **dadurch gekennzeichnet,** daß die Herstellung des eigentlichen Oberflächengitters (1) im Dunkeln und unter Ausnutzung der Anisotropie einer Dunkelätzrate des Ätzmittels erfolgt.

2. Verfahren nach Anspruch 1, **dadurch gekennzeichnet,** daß für die Herstellung des vorläufigen Oberflächengitters (4) und die Herstellung des eigentlichen Oberflächengitters (1) das gleiche Ätzmittel verwendet wird, das zumindest im Dunkeln anisotrop wirkt.

3. Verfahren nach Anspruch 1 oder 2, **dadurch gekennzeichnet,** daß zur Herstellung des eigentlichen Oberflächengitters (1) nach der Herstellung des vorläufigen Oberflächengitters (4) das vorläufige Oberflächengitter (4) im Dunkeln in dem Kontakt mit dem Ätzmittel belassen wird.

## Claims

1. Method for the wet-chemical production of a surface grating (1) having a specified grating constant (a) on the surface (2) of a substrate (3) of a crystalline material, in which method a preliminary surface grating (4) having the specified grating constant (a) but with relatively low corrugation is produced on the surface (2) of the substrate (3) by interference illumination of the surface (2) of the substrate (3) which is in direct contact with an etchant, and in which method, to produce the actual surface grating (1), the preliminary surface grating (4) is then kept for a specified time in contact with an anisotropic etchant which etches most slowly in at least one direction inclined at an angle to the surface of the substrate (3), characterised in that the actual surface grating (1) is produced in the dark by exploiting the anisotropy of a dark etching rate of the etchant.

2. Method according to Claim 1, characterised in that the same etchant which acts anisotropically at least in the dark is used for the production of the preliminary surface grating (4) and the production of the actual surface grating (1).

3. Method according to Claim 1 or 2, characterised in that, for the production of the actual surface grating (1), the preliminary surface grating (4) is left in the dark in contact with the etchant after the production of the preliminary surface grating (4).

## Revendications

1. Procédé pour former, par voie chimique humide, un réseau superficiel (1) possédant une constante déterminée (a) sur la surface (2) d'un substrat (3) réalisé en un matériau cristallin, et selon lequel on forme, sur la surface (2) du substrat (3), un réseau superficiel préliminaire (4) possédant la constante déterminée (a), mais présentant une ondulation relativement faible, au moyen d'un éclairement à interférences de la surface (2) du substrat (3), qui est directement en contact avec un agent corrosif, et selon lequel, pour former le réseau superficiel (1) proprement dit, on maintient le réseau superficiel préliminaire (4) pendant un certain intervalle de temps en contact avec un agent corrosif anisotrope qui a une action corrosive très lente dans au moins une direction oblique par rapport à la surface du substrat (3), caractérisé par le fait que la fabrication du réseau superficiel proprement dit (1) s'effectue dans l'obscurité et sur la base de l'anisotropie de la vitesse de corrosion de l'agent corrosif dans l'obscurité.

2. Procédé suivant la revendication 1, caractérisé par le fait que pour la fabrication du réseau superficiel préliminaire (4) et pour la fabrication du réseau superficiel proprement dit (1), on utilise le même agent corrosif, qui a une action anisotrope au moins dans l'obscurité.

3. Procédé suivant la revendication 1 ou 2, caractérisé par le fait que pour former le réseau superficiel proprement dit (1), après la réalisation du réseau superficiel préliminaire (4), on laisse le réseau superficiel préliminaire (4) en contact avec l'agent corrosif dans l'obscurité.

# FIG 1

# FIG 2